# FASCICULE DE BREVET EUROPEEN

(11) **EP 1 986 236 B1**
(45) Date de publication et mention de la délivrance du brevet: **06.11.2013**
(21) Numéro de dépôt: 07150134.0
(22) Date de dépôt: 19.12.2007
(51) Int. Cl.: H01L 31/0203, H01L 25/16

(54) **Procédé pour la réalisation d'un module optoélectronique, et module optoélectronique obtenu par le procédé**
Verfahren zur Herstellung eines optoelektronischen Moduls und mittels dieses Verfahrens erhaltenes optoelektronisches Modul
Method of manufacturing an optoelectronic module and optoelectronic module obtained by the method

(30) Priorité: 19.12.2006 EP 06126551
(43) Date de publication de la demande: 29.10.2008
(73) Titulaire: EM Microelectronic-Marin SA, 2074 Marin (CH)
(72) Inventeur: Kayal, Abdul-Hamid, 2000 Neuchâtel (CH); Grandjean, André, 2088 Cressier (CH)
(74) Mandataire: Couillard, Yann Luc Raymond

(56) Documents cités:
- EP-A- 0 921 426
- EP-A- 1 577 742
- WO-A-00/57352
- US-A- 4 188 708
- US-A1- 2004 084 610
- FOSTER E M ET AL: "ESD PACKAGING REQUIREMENTS FOR AN OPTO-ELECTRONIC RECEIVER MODULE" IEEE TRANSACTIONS ON COMPONENTS,HYBRIDS,AND MANUFACTURING TECHNOLOGY, IEEE INC. NEW YORK, US, vol. 13, no. 4, 1 décembre 1990 (1990-12-01), pages 787-790, XP000176824 ISSN: 0148-6411

## Description

L'invention concerne un procédé pour la réalisation d'un module optoélectronique. Ledit module optoélectronique comprend un premier circuit source de lumière et un second circuit photorécepteur susceptible de capter de la lumière provenant du premier circuit source de lumière directement ou par réflexion sur une surface extérieure. Le module optoélectronique terminé peut ainsi être utilisé par exemple dans une souris d'ordinateur pour le déplacement d'un curseur d'ordinateur.

L'invention concerne également un module optoélectronique obtenu selon le procédé.

Pour une application dans une souris d'ordinateur, il est déjà connu de monter dans un même module optoélectronique un premier circuit source de lumière et un second circuit photorécepteur. Le premier circuit source de lumière génère de la lumière passant par une première ouverture dans le matériau d'encapsulation du module, alors que le second circuit photorécepteur reçoit de la lumière réfléchie sur une surface extérieure par une seconde ouverture dans le matériau d'encapsulation. Ce circuit photorécepteur en tant que capteur comprend généralement plusieurs zones photosensibles pour capter de la lumière. Les signaux de ce capteur sont transmis habituellement à un autre circuit de traitement des signaux du capteur. En fonction de la quantité et de la variation de la lumière captée par certaines zones photosensibles du circuit photorécepteur, le circuit de traitement est en mesure de fournir des signaux de contrôle à l'ordinateur pour le déplacement d'un curseur sur l'écran de l'ordinateur.

On peut citer à ce titre les demandes de brevet EP 1 339 012 et EP 1 361 537, ainsi que la demande de brevet US 2004/0084610, qui décrivent un tel module optoélectronique. Ce module comprend donc montés sur une grille de connexion (lead frame en terminologie anglaise) un premier circuit source de lumière, qui est une diode électroluminescente, et un second circuit photorécepteur. Une lentille pour chaque circuit est fixée dans le matériau d'encapsulation dans une ouverture pour chaque circuit prévue à cet effet. La diode électroluminescente génère de la lumière qui passe à travers une première lentille, alors que le circuit photorécepteur reçoit de la lumière réfléchie sur une surface extérieure en passant par une seconde lentille.

Dans ces demandes de brevet, il n'est nullement décrit la manière de fabriquer un tel module tout en protégeant le circuit source de lumière d'éventuelles décharges électrostatiques (ESD). Un tel circuit source de lumière peut être détruit lors de l'apparition de telles décharges notamment en manipulant ledit module par des pattes métalliques externes. Ainsi, il est souvent nécessaire de connecter en plus une diode de protection de surtension (transil diode) au circuit source de lumière soit à l'intérieur dudit module, soit à l'extérieur, ce qui constitue un inconvénient.

L'invention a donc pour but principal de fournir un procédé de réalisation d'un module optoélectronique, qui permet de pallier les inconvénients de l'art antérieur cités ci-devant, de manière à protéger simplement le circuit source de lumière de toutes décharges électrostatiques pouvant survenir par des manipulations du module, et sans composants supplémentaires.

A cet effet, l'invention concerne un procédé de réalisation d'un module optoélectronique, qui comprend les caractéristiques mentionnées dans la revendication 1.

Des étapes particulières avantageuses du procédé sont définies dans les revendications dépendantes 2 à 11.

Un avantage du procédé de réalisation du module optoélectronique est qu'au moins deux pistes conductrices sur lesquelles le premier circuit source de lumière est connecté dans le premier moulage sont coupées à travers l'ouverture traversante du premier moulage. Cela permet ainsi d'isoler complètement ces deux pistes conductrices connectées au circuit source de lumière des autres parties de la grille de connexion, qui peuvent être accessibles de l'extérieur du module. Ainsi aucune piste conductrice sortant du premier moulage n'est reliée directement au circuit source de lumière. Ceci permet donc de protéger le circuit source de lumière de toutes décharges électrostatiques pouvant survenir en manipulant des pistes conductrices externes du module. La protection du circuit source de lumière est ainsi obtenue sans le montage d'une diode supplémentaire de protection de surtension, ce qui réduit les coûts de fabrication du module optoélectronique.

Grâce au procédé de réalisation du module optoélectronique, cela permet également d'avoir une alimentation électrique et un entraînement découplés entre le premier circuit source de lumière et le second circuit photorécepteur. De cette manière, il est possible de concevoir un circuit capteur polyvalent à plusieurs fonctions électroniques.

Un autre avantage du procédé de réalisation du module optoélectronique est qu'avec l'ouverture traversante dans le premier moulage donnant accès à deux pistes conductrices de la grille de connexion, cela permet de faciliter une opération de chauffage de toute la grille de connexion. En chauffant la grille de connexion par les deux pistes conductrices, chaque circuit peut être facilement relié par fils métalliques à des plages correspondantes des pistes de la grille de connexion. La connexion du second circuit photorécepteur est effectuée avant la connexion du premier circuit source de lumière de manière à le protéger d'éventuelles décharges électrostatiques lors de cette étape de connexion.

Un autre avantage du procédé de réalisation du module optoélectronique est qu'il est réalisé un second moulage avec un matériau d'encapsulation sur le premier moulage en laissant une première ouverture au-dessus du premier circuit source de lumière et une seconde ouverture au-dessus du second circuit photorécepteur. La première ouverture définit un logement pour le placement d'une lentille au-dessus du premier circuit source de lumière. Grâce au second moulage, l'ouverture traversante est bouchée, ce qui permet de rendre le module plus résistant aux chocs mécaniques.

Des trous de positionnement peuvent être avantageusement réalisés dans la grille de connexion, le premier moulage et le second moulage pour faciliter la réalisation de toutes les étapes de fabrication du module optoélectronique. Au moins deux trous de positionnement au terme de l'étape de réalisation du second moulage subsistent pour le montage et le positionnement d'un bloc transparent sur les ouvertures du second moulage. La surface du bloc transparent, qui vient en contact du second moulage, a une forme complémentaire à la surface extérieure du second moulage. De cette manière, une portion sous forme de lentille du bloc transparent vient se loger dans la première ouverture du second moulage en étant guidé par deux tiges du bloc transparent insérées dans les deux trous de positionnement.

Avantageusement, le bloc transparent peut être fixé sur le bloc de résine de forme sensiblement parallélépipédique, qui est constitué des premier et second moulages à l'aide de moyens d'accrochage. Pour un bloc transparent réalisé en plastique sans couleur, ces moyens d'accrochage peuvent comprendre des languettes à crochet disposées sur deux côtés opposés pour venir s'accrocher sur une face opposée du bloc de résine.

A cet effet, l'invention concerne également un module optoélectronique obtenu par le procédé, qui comprend les caractéristiques définies dans la revendication 12.

Des formes d'exécution spécifiques du module optoélectronique sont définies dans les revendications dépendantes 13 à 15.

Les buts, avantages et caractéristiques du procédé de réalisation du module optoélectronique, et dudit module obtenu par le procédé apparaîtront mieux dans la description suivante d'une forme d'exécution non limitative illustrée par les dessins sur lesquels :
la figure 1 représente une vue tridimensionnelle en éclaté d'un module optoélectronique selon l'invention à fixer à une plaque à circuit imprimé,
les figures 2A à 2G représentent en vue tridimensionnelle des composants du module optoélectronique dans les étapes successives du procédé de réalisation dudit module optoélectronique selon l'invention, et
la figure 3 représente de manière simplifiée une vue de côté en coupe partielle d'une souris d'ordinateur, qui comprend le module optoélectronique selon l'invention, sur une surface de travail.

Dans la description suivante, toutes les parties du module optoélectronique qui sont bien connues d'un homme du métier dans ce domaine technique ne sont relatées que de manière simplifiée. De préférence, ce module optoélectronique est réalisé pour une utilisation dans une souris d'ordinateur, mais il peut être envisagé d'obtenir un tel module par le procédé de réalisation du module selon l'invention pour une utilisation dans un autre instrument ou appareil électrique.

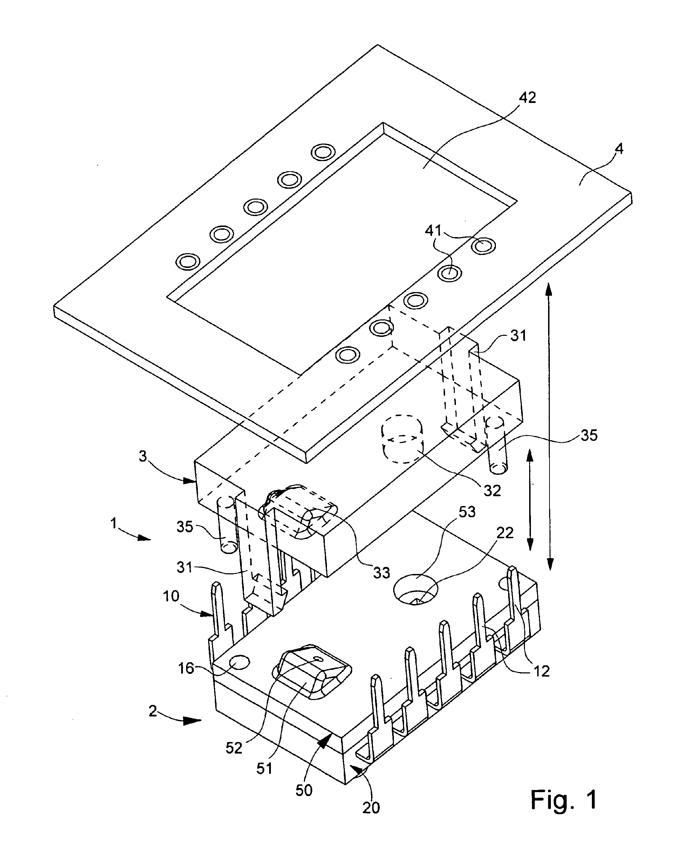

La figure 1 montre une vue tridimensionnelle en éclaté du module optoélectronique 1, qui est obtenu par le procédé de réalisation du module selon l'invention, à fixer sur une plaque à circuit imprimé 4. Ce module optoélectronique 1, 2 comprend encapsulé dans un premier moulage 20 et un second moulage 50, un premier circuit source de lumière et un second circuit photorécepteur, non représentés à la figure 1. Une première ouverture 22, 53 est réalisée dans les premier et second moulages, qui sont réalisés avec un matériau d'encapsulation, tel que de la résine opaque, pour le passage de la lumière générée par le premier circuit source de lumière. Une seconde ouverture 52 est réalisée dans une partie en saillie 51 du second moulage pour la réception de lumière du second circuit photorécepteur. Cette lumière reçue est essentiellement la lumière fournie par le premier circuit source de lumière, qui est réfléchie sur une surface extérieure. Cette seconde ouverture est formée comme un diaphragme. Le second moulage 50 est ainsi réalisé pour recouvrir une zone électronique de traitement de signaux du second circuit photorécepteur, alors qu'une zone optoélectronique du second circuit photorécepteur capte la lumière réfléchie à travers le passage de la seconde ouverture.

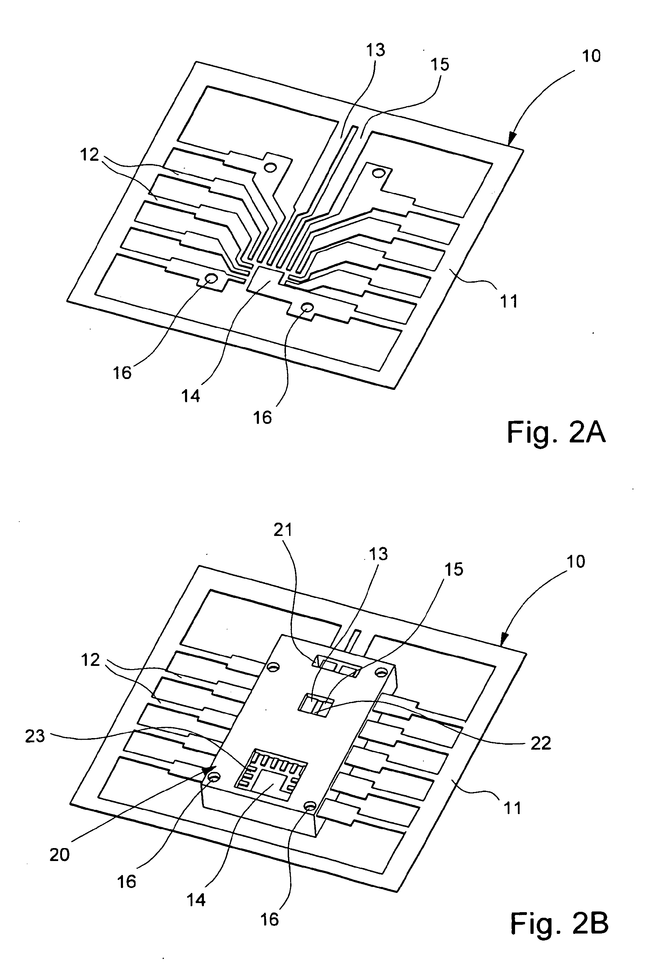

Des parties de certaines pistes conductrices, par exemple en métal, 12 d'une grille de connexion 10 sortent de deux côtés opposés du premier moulage 20 pour former après pliage des pattes de connexion du module optoélectronique 1. Les pattes de connexion sont régulièrement espacées et en nombre égal d'un côté et de l'autre du premier moulage. Au moins certaines pistes métalliques 12 sont reliées comme expliqué ci-après en référence aux figures 2A à 2G au second circuit photorécepteur, car le premier circuit source de lumière est connecté à deux pistes conductrices de la grille non accessibles depuis l'extérieur du module. De cette manière sans ajout de diode de protection, le premier circuit source de lumière est isolé de l'extérieur du module, ce qui permet de le protéger de toutes décharges électrostatiques (ESD) lors de manipulation du module optoélectronique.

Le module optoélectronique 1 peut n'être constitué sous la référence 2 que du bloc de résine opaque de forme générale parallélépipédique constitué par les premier et second moulage 20, 50, des premier et second circuits et des pattes de connexion 12 de la grille de connexion 10. Ce module optoélectronique peut ainsi être réalisé sous la forme d'un composant électronique à pattes de connexion de type DIP standard, avec les deux ouvertures situées au-dessous dudit module. Cependant, ce module peut comprendre également un bloc transparent 3 placé sur les première et seconde ouvertures 53, 52 du second moulage. Ce bloc transparent, qui bouche ainsi les deux ouvertures 53, 52, peut permettre également de protéger les premier et second circuits de la poussière et des conditions de l'environnement.

Ce bloc transparent 3 peut être réalisé en verre ou de préférence en plastique. La surface de ce bloc transparent, qui vient en contact sur le second moulage 50, peut être de forme complémentaire à la surface extérieure de dessous du second moulage. Ainsi, une portion sous forme de lentille 32 du bloc transparent peut venir se loger dans le logement cylindrique 53 de la première ouverture du second moulage 50. De plus, une portion complémentaire 33 du bloc transparent vient couvrir la partie en saillie 51 du second moulage et la seconde ouverture 52 de réception de lumière.

Pour faciliter le positionnement de ce bloc transparent sur le second moulage, il est prévu au moins deux trous de positionnement 16 réalisés dans deux angles opposés des premier et second moulages 20, 50, et dans la grille de connexion 10 comme expliqué ci-après. Le bloc transparent 3 comprend donc deux tiges 35 de diamètre inférieur ou égal au diamètre des trous de positionnement pour être guidées dans les deux trous lors du montage du bloc transparent sur le bloc de résine opaque 20, 50. Les extrémités libres de ces tiges 35 peuvent être arrondies ou chanfreinées pour faciliter leur introduction dans les deux trous de positionnement 16.

Le bloc transparent 3 peut être fixé sur le second moulage 50 avec de la colle ou grâce à des moyens d'accrochage 31. Ces moyens d'accrochage peuvent être de préférence deux languettes à crochet 31 venant de matière avec le bloc transparent et s'étendant dans une direction verticale par rapport au module optoélectronique 2. Les deux languettes sont disposées sur deux côtés opposés du bloc transparent pour venir en contact sur deux faces du module sans pattes de connexion 12. Ces languettes 31 possèdent chacune à une extrémité libre un crochet. Les crochets sont formés chacun avec un plan incliné pour faire fléchir chaque languette lors de la fixation du bloc transparent sur le second moulage. Ces crochets viennent finalement s'accrocher sur une face de dessus du bloc de résine du module optoélectronique 2.

Le module optoélectronique 1, qui comprend le bloc de résine 2 et le bloc transparent 3 fixé sur le bloc de résine opaque, peut être monté sur une plaque à circuit imprimé 4. Les pattes de connexion 12 peuvent être insérées et soudées dans des trous métallisés 41 de la plaque à circuit imprimé 4. Une ouverture 42 de la plaque à circuit imprimé 4 est également prévue de dimension suffisante pour permettre l'émission de lumière du premier circuit source de lumière et la réception de lumière réfléchie du second circuit photorécepteur.

Le procédé de réalisation du module optoélectronique est expliqué ci-après en référence aux figures 2A à 2G.

II est tout d'abord formé une grille de connexion de forme générale plane, comme montrée à la figure 2A. Cette grille de connexion 10 est de préférence réalisée à l'aide d'une tôle ou feuille métallique d'épaisseur inférieure ou égale à 1 mm, et de longueur et largeur chacune inférieure à 3 cm. Bien entendu, il pourrait être envisagé également de la réaliser au moyen d'un substrat conducteur fixé sur un substrat isolant. De plus, il peut être imaginé également une bande de plusieurs grilles de connexion pour le montage simultané de plusieurs modules optoélectroniques.

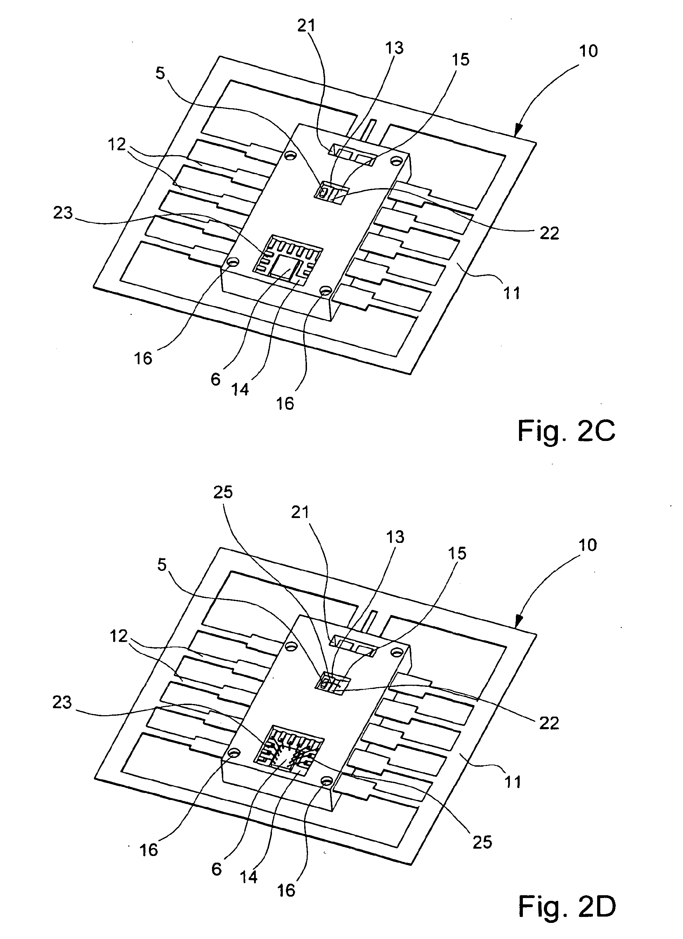

Dans la forme d'exécution de la figure 2A, cette grille de connexion comprend un certain nombre de pistes conductrices 12, par exemple métalliques. Une seule extrémité de toutes les pistes métalliques de connexion est reliée à une barrette de liaison ou de préférence à plusieurs barrettes de liaison 11 formant un cadre extérieur. Une première piste métallique 13 comprend une portion sur laquelle peut être monté le premier circuit source de lumière. Cette portion est située de préférence au milieu de la piste métallique 13 comme expliquée ci-après en référence à la figure 2C. Une troisième piste métallique 15 disposée parallèlement à la première piste métallique 13 est prévue pour être connectée à une plage de contact du premier circuit source de lumière. Une seconde piste métallique 14 comprend une portion à l'extrémité libre de cette piste sur laquelle peut être monté le second circuit photorécepteur. Cette portion est située dans une région centrale de la grille de connexion 10 à proximité des extrémités libres des première et troisième pistes métalliques 13 et 15.

Un nombre égal de pistes métalliques de connexion 12 régulièrement espacées est relié sur deux côtés opposés du cadre métallique 11 de la grille de connexion 10, pour définir en fin de procédé des pattes conductrices de connexion du module optoélectronique. Par contre, les première et troisième pistes métalliques 13 et 15 sont reliées dans une direction perpendiculaire aux autres pistes métalliques sur un côté du cadre métallique reliant les deux côtés opposés.

La grille de connexion comprend encore plusieurs trous de positionnement 16 de préférence en nombre égal à quatre, qui sont réalisés chacun dans une piste métallique de connexion. De préférence, ces quatre trous de positionnement 16 sont réalisés perpendiculaires au plan de la grille de connexion 10 dans les première et dernière pistes métalliques reliées aux deux côtés opposés du cadre métallique 11. Ces trous de positionnement sont utilisés pour faciliter visuellement et/ou mécaniquement les diverses opérations de réalisation du module optoélectronique. Ils sont de préférence situés dans une région centrale de la grille sur laquelle sont réalisés les premier et second moulages expliqués ci-après.

La figure 2B montre un premier moulage 20 avec un matériau d'encapsulation, tel que de la résine plastique opaque traditionnelle, qui est réalisé sur une partie de la grille de connexion 10 par le procédé de réalisation du module optoélectronique selon l'invention. Ce premier moulage peut être obtenu au moyen d'un moule en deux parties. Une première partie du moule est disposée sous la grille de connexion 10 dans une position centrale, alors qu'une seconde partie du moule est disposée sur la grille au-dessus de la première partie du moule. Les deux parties du moule, non représentées, sont maintenues l'une sur l'autre au moyen de tiges passant à travers les quatre trous de positionnement 16. De la pâte de résine plastique opaque traditionnelle est injectée et solidifiée dans le moule afin de produire sur une partie de la grille 10 un premier moulage 20 formant un premier bloc de résine de forme générale extérieure parallélépipédique. Les trous de positionnement 16 ne sont en principe pas bouchés par ce premier moulage 20.

Ce premier moulage 20 enrobe complètement au moins une partie intermédiaire des pistes métalliques 12 de la grille de connexion 10 tout en laissant des première et seconde régions rectangulaires découvertes 22, 23 sur une face de la grille de connexion. Une zone intermédiaire des première et troisième pistes métalliques 13, 15 est donc découverte d'un côté de la grille de connexion 10 dans la première région 22 pour permettre le placement et la connexion du premier circuit source de lumière. Les extrémités libres de la seconde piste métallique 14 et des autres pistes métalliques 12 sont découvertes du même côté de la grille de connexion dans la seconde région 23 pour permettre le placement et la connexion du second circuit photorécepteur.

Le premier moulage 20 comprend encore une ouverture traversante 21 de forme rectangulaire située entre le cadre 11 de la grille de connexion et la première région découverte 22 pour donner accès aux première et troisième pistes métalliques 13, 15. Cette ouverture traversante est nécessaire pour opérer certaines étapes intermédiaires du procédé de réalisation du module objet de l'invention.

Une fois réalisé le premier moulage 20 sur une partie centrale de la grille de connexion, le premier circuit intégré source de lumière 5 est fixé du côté dos à l'aide d'une colle conductrice sur la première piste métallique 13 dans la première région 22, comme montré à la figure 2C. Le premier circuit source de lumière est de préférence une diode laser. Le second circuit intégré photorécepteur 6 est quant à lui fixé du côté dos à l'aide d'une colle conductrice sur une portion d'extrémité de la seconde piste métallique 14. Ce second circuit intégré photorécepteur 6 est avantageusement réalisé dans un substrat semi-conducteur en silicium. Il comprend une zone optoélectronique ayant plusieurs portions photosensibles traditionnelles pour capter de la lumière réfléchie provenant de la diode laser, et une zone électronique de traitement de signaux des portions photosensibles de la zone optoélectronique.

Comme montré à la figure 2D, des plages de contact du second circuit photorécepteur 6 sont tout d'abord reliées par des fils métalliques de connexion 25 à des plages correspondantes de la grille de connexion, qui sont situées aux extrémités libres d'au moins certaines pistes métalliques 12. La connexion de ce second circuit photorécepteur est réalisée de préférence avec des fils métalliques en aluminium. Grâce à l'ouverture traversante 21 réalisée dans le premier moulage 20, il est possible de chauffer la grille de connexion 10 sur les première et troisième pistes métalliques 13 et 15 à travers l'ouverture traversante pour réaliser facilement la connexion par fils métalliques du second circuit photorécepteur.

Une plage de contact sur le dessus du premier circuit source de lumière 5, qui est de préférence une diode laser, est reliée dans la première région découverte 22 par un fil métallique à la troisième piste métallique 15. Le fil métallique est de préférence un fil en or. Tout comme pour le second circuit photorécepteur 6, les première et troisième pistes métalliques 13 et 15 sont avantageusement chauffées par une sonde thermique à travers l'ouverture traversante pour l'opération de connexion électrique du premier circuit source de lumière 5. Le premier circuit source de lumière 5 est relié par l'intermédiaire des première et troisième pistes métalliques 13, 15 à des plages de contact du second circuit photorécepteur 6, qui comprend des diodes de protection pour le premier circuit source de lumière 5.

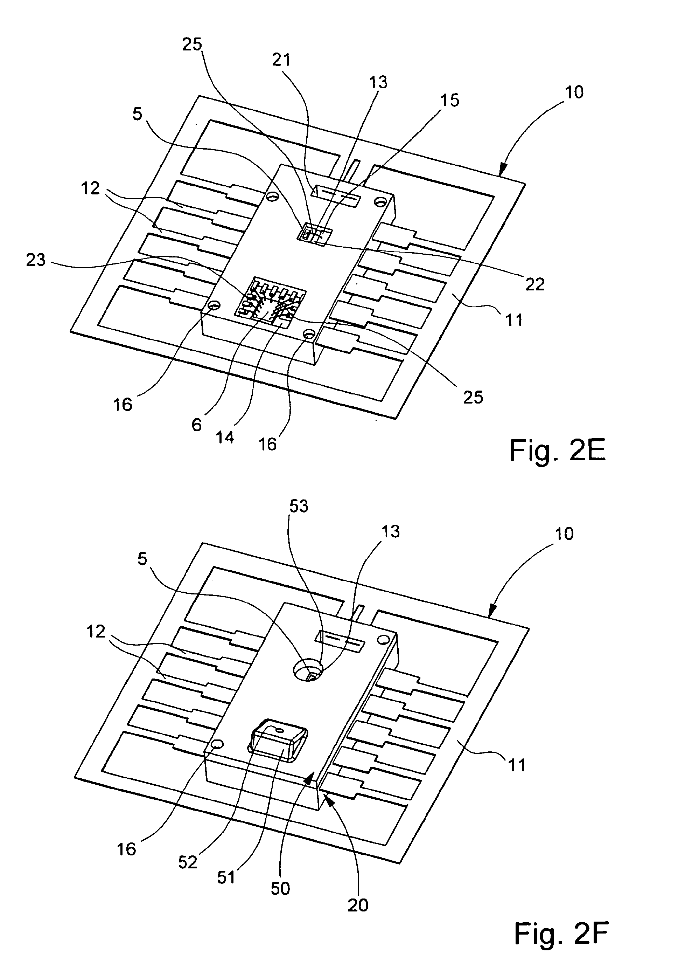

Après l'opération de connexion électrique des premier et second circuits intégrés, les première et troisième pistes métalliques 13, 15 sont avantageusement coupées à travers l'ouverture traversante 21 comme montré à la figure 2E. Les première et troisième pistes métalliques 13, 15 reliant le premier circuit source de lumière 5 ne sont donc plus reliées électriquement aux autres parties de la grille de connexion 10. De cette manière, le premier circuit source de lumière 5 est isolé électriquement des parties de la grille de connexion accessibles de l'extérieur du premier moulage 20. Cela permet de ce fait de protéger le premier circuit source de lumière 5 de décharges électrostatiques sans devoir monter une diode supplémentaire de protection de surtension. Uniquement, des diodes de protection sont prévues dans le second circuit photorécepteur pour éventuellement protéger le premier circuit source de lumière très sensible de décharges électrostatiques (ESD).

II est à noter également qu'en coupant les première et troisième pistes métalliques 13, 15 à travers l'ouverture traversante 21 réalisée dans le premier moulage 20, cela évite également d'avoir accès directement aux parties coupées de ces pistes. Ces pistes métalliques 13, 15 peuvent être coupées par exemple à l'aide d'un faisceau laser.

Après avoir coupé les première et troisième pistes métalliques à travers l'ouverture traversante, un second moulage 50 avec un matériau d'encapsulation est réalisé sur une face du premier moulage 20 comme montré à la figure 2F. Le matériau d'encapsulation du second moulage 50 peut être constitué d'une même résine plastique que celle utilisée pour le premier moulage 20. Le second moulage 50 forme avec le premier moulage un bloc de résine opaque de forme générale sensiblement parallélépipédique.

Avec le second moulage 50, l'ouverture traversante est totalement bouchée, ainsi que deux des quatre trous de positionnement 16, ce qui permet de rendre le module plus résistant aux chocs mécaniques. Les deux trous non bouchés à proximité de deux angles diamétralement opposés sont des trous de section circulaire et disposés dans une direction perpendiculaire à la grille de connexion 10.

Une fois réalisé sur le premier moulage 20, le second moulage 50 comprend une première ouverture 53 au-dessus du premier circuit source de lumière 5. Cette première ouverture circulaire 53 définit avec le premier moulage un logement pour une lentille optique. Le diamètre de cette première ouverture est de préférence de plus grande dimension que le premier circuit source de lumière pour laisser un grand angle d'ouverture pour la lumière produite par le premier circuit source de lumière 5.

Une seconde ouverture 52 de réception de lumière pour le second circuit photorécepteur est réalisée dans une partie en saillie 51 du second moulage opaque 50. Cette seconde ouverture sous la forme d'un diaphragme forme un passage pour la lumière réfléchie sur une surface extérieure et produite par le premier circuit source de lumière 5. Le second moulage 50 est également réalisé pour recouvrir uniquement une zone électronique de traitement de signaux du second circuit photorécepteur, en laissant une zone optoélectronique découverte pour capter de la lumière à travers la seconde ouverture 52.

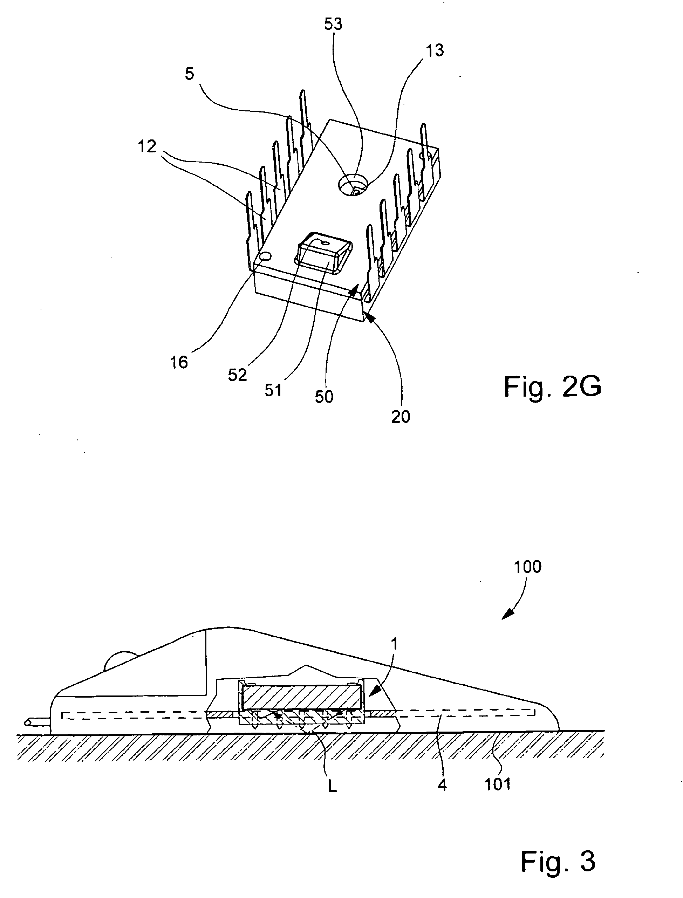

A la figure 2G, le module optoélectronique 2 est représenté une fois toutes les opérations terminées d'encapsulation des premier et second circuits intégrés. Le cadre de la grille de connexion est coupé et les pistes métalliques 12 sur les deux côtés opposés du premier moulage 20 sont repliées du côté des première et seconde ouverture 52, 53 du second moulage 50. Les pistes métalliques repliées 12 forment ainsi des pattes de connexion électrique du module optoélectronique 2. Les parties résiduelles des première et troisième pistes métalliques sont également coupées à fleur du côté du module reliant les deux côtés opposés ayant les pattes de connexion. Ce module optoélectronique terminé 2 peut également être complété en montant un bloc transparent à lentille optique guidé et positionné par les deux trous de positionnement 16 comme décrit ci-dessus en référence à la figure 1.

Le module optoélectronique complet 1 peut donc équiper une souris d'ordinateur 100 comme montré de manière simplifiée à la figure 3. Le module optoélectronique est monté sur une plaque à circuit imprimé 4, qui comprend une ouverture au-dessous du module pour le passage de la lumière L. La lumière est générée par le premier circuit source de lumière, qui est de préférence une diode laser. Cette lumière passe à travers la première ouverture du module et une lentille du bloc transparent fixé sur le dessous du module. Cette lumière L est réfléchie sur une surface de travail 101 de la souris d'ordinateur 100 et reçue par plusieurs portions photosensibles du second circuit photorécepteur à travers le bloc transparent et la seconde ouverture du module. Les signaux traités par le second circuit photorécepteur sont transmis à une station d'ordinateur de manière traditionnelle notamment pour commander le déplacement d'un curseur d'écran.

A partir de la description qui vient d'être faite, de multiples variantes de réalisation du procédé de réalisation du module optoélectronique, et du module obtenu peuvent être conçues par l'homme du métier sans sortir du cadre de l'invention définie par les revendications. II peut être prévu d'avoir un module optoélectronique avec des pattes de connexion ne sortant que d'un seul côté du bloc de résine, qui peut prendre une forme autre qu'une forme générale parallélépipédique. Toutes les pistes conductrices de la grille de connexion peuvent de ce fait n'être reliées qu'à une seule barrette de liaison externe. Il peut encore être prévu de monter une lentille sur la seconde ouverture du module pour la réception de la lumière ou de n'avoir qu'une seule lentille fixée directement dans le logement de la première ouverture du second moulage.

## Revendications

1. Procédé pour la réalisation d'un module optoélectronique (1, 2), qui comprend un premier circuit source de lumière (5) et un second circuit photorécepteur (6) susceptible de capter de la lumière provenant du premier circuit source de lumière directement ou par réflexion sur une surface extérieure, le procédé comprenent des étapes de :
- réaliser un premier moulage (20) avec un matériau d'encapsulation sur une grille de connexion (10) sur laquelle sont placés avant ou après le premier moulage et sur au moins une partie (22, 23) d'une face de la grille de connexion non recouverte par le premier moulage, le premier circuit source de lumière (5) sur une portion d'une première piste conductrice (13) de la grille de connexion et le second circuit photorécepteur (6) sur une portion d'une seconde piste conductrice (14) de la grille de connexion, les première et seconde pistes conductrices de connexion, ainsi que d'autres pistes conductrices de connexion (12) de la grille de connexion étant reliées à l'extérieur du premier moulage à au moins une barrette de liaison (11), une ouverture traversante (21) étant réalisée dans le premier moulage (20) entre la barrette de liaison et l'emplacement du premier circuit source de lumière pour donner accès à la première piste conductrice (13) et à une troisième piste conductrice de connexion (15) pour le premier circuit source de lumière,
- relier électriquement des plages de contact des premier et second circuits (5, 6) à des plages correspondantes découvertes de certaines pistes conductrices (12) de la grille de connexion (10), le premier circuit source de lumière étant relié par l'intermédiaire des première et troisième pistes conductrices à des plages de contact du second circuit photorécepteur, et
- couper les première et troisième pistes conductrices de connexion (13, 15) à travers l'ouverture traversante (21) du premier moulage pour isoler électriquement le premier circuit source de lumière des parties de la grille de connexion accessibles à l'extérieur du premier moulage, ledit premier circuit source de lumière n'étant relié vers l'extérieur que par l'intermédiaire du second circuit photorécepteur, afin de protéger le circuit source de lumière de décharges électrostatiques.

2. Procédé selon la revendication 1, **caractérisé en ce qu'**un second moulage (50) avec un matériau d'encapsulation est réalisé sur le premier moulage (20) de manière à boucher l'ouverture traversante (21) après avoir coupé les première et troisième pistes conductrices (13, 15) et à former une première ouverture (53) sur le premier circuit source de lumière pour le passage de la lumière générée par ledit premier circuit (5), et une seconde ouverture de réception de lumière (52) sur le second circuit photorécepteur (6).

3. Procédé selon la revendication 2, **caractérisé en ce que** la seconde ouverture (52) est réalisée dans une partie en saillie (51) du second moulage opaque (50) pour former un passage de lumière sous la forme d'un diaphragme, et **en ce que** le second moulage est réalisé pour recouvrir une zone électronique de traitement de signaux du second circuit photorécepteur, alors qu'une zone optoélectronique du second circuit photorécepteur est destinée à capter de la lumière à travers le passage de lumière du second moulage.

4. Procédé selon l'une des revendications précédentes, **caractérisé en ce que** le premier moulage opaque (20) est réalisé comme un bloc de résine de forme générale sensiblement parallélépipédique sur une partie centrale de la grille de connexion (10), qui comprend plusieurs barrettes formant un cadre de liaison (11) des pistes conductrices en métal (12), extérieur au premier moulage, un nombre égal de pistes conductrices en métal régulièrement espacées sortant de deux côtés opposés du bloc de résine du premier moulage, alors que les première et troisième pistes conductrices en métal (13, 15) pour le premier circuit source de lumière (5) sortent d'un troisième côté dudit bloc de résine.

5. Procédé selon l'une des revendications 2 et 4, **caractérisé en ce que** le second moulage opaque (50) est réalisé sur le premier moulage opaque (20) du côté de la grille de connexion (10) supportant les premier et second circuits (5, 6), pour former avec le premier moulage un bloc de résine de forme générale sensiblement parallélépipédique, et **en ce que** le second moulage est réalisé sur le premier moulage avec une première ouverture (53) pour le passage de la lumière générée par ledit premier circuit (5), qui définit avec le premier moulage un logement pour une lentille optique (32), ladite première ouverture étant de plus grande dimension que le premier circuit source de lumière, et une seconde ouverture (52) pour la réception de la lumière sur le second circuit photorécepteur (6).

6. Procédé selon l'une des revendications 1 et 4, **caractérisé en ce que** le premier moulage opaque (20) est réalisé sur la grille de connexion (10) à l'aide de trous de positionnement (16) dans des pistes conductrices de connexion (12) de la grille, lesdits trous de positionnement, de préférence en nombre égal à quatre, n'étant pas bouchés par le premier moulage et situés dans une direction perpendiculaire à la grille de connexion (10) à proximité des angles du bloc du premier moulage (20) une fois réalisé.

7. Procédé selon la revendication 6, **caractérisé en ce que** le second moulage opaque (50) est réalisé sur le premier moulage opaque (20) sans boucher deux trous de positionnement (16) situés à deux angles opposés d'un bloc de résine une fois réalisé, qui est constitué par les premier et second moulages, **en ce que** la barrette de liaison ou le cadre de liaison (11) de la grille de connexion (10) sont découpés et **en ce que** les pistes conductrices en métal (12) sortant de deux côtés opposés du bloc de résine sont pliées pour former des pattes de connexion électrique du module optoélectronique (1, 2).

8. Procédé selon la revendication 1, **caractérisé en ce qu'**après avoir réalisé le premier moulage (20) sur la grille de connexion (10), les premier et second circuits (5, 6) sont fixés respectivement sur une portion des première et seconde pistes conductrices en métal (13, 14), et **en ce que** des plages de contact des premier et second circuits sont reliés par des fils métalliques de connexion (25) à des plages correspondantes de la grille de connexion au moyen d'un chauffage de la grille de connexion opéré sur les première et troisième pistes conductrices en métal (13, 15) à travers l'ouverture traversante (21).

9. Procédé selon l'une des revendications 2, 5 et 7, **caractérisé en ce qu'**un bloc de matériau transparent (3), qui comprend au moins une lentille (32) pour le premier circuit source de lumière (5), est réalisé pour être monté sur les première et seconde ouvertures (53, 52) du second moulage (50), la partie du bloc transparent venant en contact du second moulage ayant une forme complémentaire à une surface extérieure du second moulage de manière qu'une portion sous forme de lentille du bloc transparent vienne se loger dans la première ouverture (53) du second moulage.

10. Procédé selon la revendication 9, pour lequel le bloc transparent (3) est réalisé en verre ou en matériau plastique, **caractérisé en ce que** le bloc transparent est réalisé avec deux tiges de positionnement (35) afin d'être monté et positionné sur le second moulage à travers deux trous de positionnement (16) réalisés à travers un bloc de résine constitué par les premier et second moulages, et la grille de connexion.

11. Procédé selon la revendication 10, **caractérisé en ce que** le bloc transparent est fixé au bloc de résine mécaniquement par des moyens d'accrochage (31) venant de matière avec le bloc transparent ou collé au bloc de résine.

12. Module optoélectronique (1, 2) qui peut être obtenu par le procédé selon l'une des revendications précédentes, ledit module comprenant monté sur un côté d'une grille de connexion (10) uniquement un premier circuit source de lumière (5) placé sur une portion d'une première piste conductrice (13) de la grille de connexion, et un second circuit photorécepteur (6) placé sur une portion d'une seconde piste conductrice (14) de la grille de connexion, des plages de contact des premier et second circuits étant reliées par des fils métalliques (25) à des plages correspondantes découvertes de certaines pistes conductrices (12) de la grille de connexion (10), ledit premier circuit source de lumière étant relié par l'intermédiaire de la première piste conductrice et d'une troisième piste conductrice à des plages de contact du second circuit photorécepteur, le module comprenent au moins un premier moulage (20) réalisé avec un matériau d'encapsulation sur une partie centrale de la grille de connexion, et un certain nombre de pistes conductrices de connexion (12) sortant du premier moulage, **caractérisé en ce que** le premier circuit source de lumière n'est relié vers l'extérieur que par l'intermédiaire du second circuit photorécepteur afin de le protéger de décharges électrostatiques.

13. Module optoélectronique selon la revendication 12, **caractérisé en ce qu'**il comprend un second moulage (50) réalisé avec un matériau d'encapsulation sur le premier moulage (20) du côté de la grille de connexion (10) supportant les premier et second circuits (5, 6) pour former avec le premier moulage un bloc de résine de forme générale sensiblement parallélépipédique, et **en ce que** le second moulage est réalisé sur le premier moulage avec une première ouverture (53) pour le passage de la lumière générée par ledit premier circuit, qui définit avec le premier moulage un logement pour une lentille optique (32), ladite première ouverture étant de plus grande dimension que le premier circuit source de lumière, et une seconde ouverture (52) pour la réception de la lumière sur le second circuit photorécepteur, ladite seconde ouverture étant réalisée dans une partie en saillie (51) du second moulage opaque pour former un passage de lumière sous la forme d'un diaphragme, et **en ce que** le second moulage est réalisé pour recouvrir une zone électronique de traitement de signaux du second circuit photorécepteur, alors qu'une zone optoélectronique du second circuit photorécepteur est destinée à capter de la lumière à travers le passage de lumière du second moulage.

14. Module optoélectronique selon la revendication 13, **caractérisé en ce que** le module comprend en outre un bloc de matériau transparent (3) monté sur les première et seconde ouvertures (53, 52) du second moulage, la partie du bloc transparent venant en contact du second moulage ayant une forme complémentaire à une surface extérieure du second moulage de manière qu'une portion sous forme de lentille (32) du bloc transparent vienne se loger dans la première ouverture (53) du second moulage pour le premier circuit source de lumière (5), qui est de préférence une diode laser.

15. Module optoélectronique selon la revendication 14, pour lequel le bloc transparent (3) est réalisé en verre ou en matériau plastique, **caractérisé en ce que** le bloc transparent comprend deux tiges de positionnement (35) insérées dans deux trous de positionnement (16) réalisés dans le bloc de résine constitué par les premier et second moulages (20, 50), et **en ce que** le bloc transparent comprend sur deux côtés opposés des moyens d'accrochage sous la forme de languettes à crochet (31) pour s'accrocher sur une face dudit bloc de résine opposée à la face de contact du bloc transparent sur le second moulage.

## Patentansprüche

1. Verfahren für die Herstellung eines optoelektronischen Moduls (1, 2), das eine erste Lichtquellenschaltung (5) und eine zweite Photoempfängerschaltung (6), die das Licht, das direkt von der ersten Lichtquellenschaltung oder über eine Reflexion an einer äußeren Oberfläche ankommt, empfangen kann, umfasst, wobei das Verfahren die folgenden Schritte umfasst:
- Herstellen eines ersten Formteils (20) mit einem Einkapselungsmaterial auf einem Anschlussgitter (10), auf dem vor oder nach dem ersten Formteil und wenigstens auf einem Teil (22, 23) einer Fläche des Anschlussgitters, der nicht von dem ersten Formteil abgedeckt ist, die erste Lichtquellenschaltung (5) auf einem Abschnitt einer ersten Leiterbahn (13) des Anschlussgitters und die zweite Photoempfängerschaltung (6) auf einem Abschnitt einer zweiten Leiterbahn (14) des Anschlussgitters angeordnet werden, wobei die erste und die zweite Anschluss-Leiterbahn sowie weitere Anschluss-Leiterbahnen (12) des Anschlussgitters außerhalb des ersten Formteils mit wenigstens einem Verbindungssteg (11) verbunden sind, wobei in dem ersten Formteil (20) zwischen dem Verbindungssteg und dem Ort der ersten Lichtquellenschaltung eine Durchgangsöffnung (21) verwirklicht ist, um einen Zugang zu der ersten Leiterbahn (13) und zu einer dritten Anschluss-Leiterbahn (15) für die erste Lichtquellenschaltung zu schaffen,
- elektrisches Verbinden von Kontaktbereichen der ersten und der zweiten Schaltung (5, 6) mit entsprechenden abgedeckten Bereichen bestimmter Leiterbahnen (12) des Anschlussgitters (10), wobei die erste Lichtquellenschaltung über die erste und die dritte Leiterbahn mit Kontaktbereichen der zweiten Photoempfängerschaltung verbunden wird, und
- Unterbrechen der ersten und der dritten Anschluss-Leiterbahn (13, 15) durch die Durchgangsöffnung (21) des ersten Formteils hindurch, um die erste Lichtquellenschaltung von Teilen des Anschlussgitters, die von außerhalb des ersten Formteils zugänglich sind, elektrisch zu isolieren, wobei die erste Lichtquellenschaltung mit der äußeren Umgebung nur über die zweite Photoempfängerschaltung verbunden ist, um die Lichtquellenschaltung vor elektrostatischen Entladungen zu schützen.

2. Verfahren nach Anspruch 1, **dadurch gekennzeichnet, dass** ein zweites Formteil (50) mit einem Einkapselungsmaterial auf dem ersten Formteil (20) hergestellt wird, derart, dass die Durchgangsöffnung (21), nachdem die erste und die dritte Leiterbahn (13, 15) durchtrennt worden sind, verschlossen wird und eine erste Öffnung (53) auf der ersten Lichtquellenschaltung für den Durchgang des Lichts, das von der ersten Schaltung (5) erzeugt wird, und eine zweite Lichtempfangsöffnung (52) auf der zweiten Photoempfängerschaltung (6) gebildet werden.

3. Verfahren nach Anspruch 2, **dadurch gekennzeichnet, dass** die zweite Öffnung (52) in einem vorstehenden Teil (51) des lichtundurchlässigen zweiten Formteils (50) in Form einer Membran verwirklicht wird, um einen Lichtdurchgang zu bilden, und dass das zweite Formteil hergestellt wird, um eine elektronische Signalverarbeitungszone der zweiten Lichtempfängerschaltung abzudecken, während eine optoelektronische Zone der zweiten Photoempfängerschaltung dazu bestimmt ist, Licht durch den Lichtdurchgang des zweiten Formteils zu empfangen.

4. Verfahren nach einem der vorhergehenden Ansprüche, **dadurch gekennzeichnet, dass** das erste lichtundurchlässige Formteil (20) als ein Harzblock im Wesentlichen mit einer allgemeinen Spatform auf einem mittleren Teil des Anschlussgitters (10) hergestellt wird, der mehrere Stege umfasst, die einen Verbindungsrahmen (11) für die Metall-Leiterbahnen (12) außerhalb des ersten Formteils bilden, wobei von zwei gegenüberliegenden Seiten des Harzblocks des ersten Formteils eine jeweils gleiche Anzahl von Metall-Leiterbahnen, die regelmäßig beabstandet sind, ausgehen, während die erste und die dritte Metall-Leiterbahn (13, 15) für die erste Lichtquellenschaltung (5) von einer dritten Seite des Harzblocks ausgehen.

5. Verfahren nach einem der Ansprüche 2 und 4, **dadurch gekennzeichnet, dass** das zweite lichtundurchlässige Formteil (50) auf dem ersten lichtundurchlässigen Formteil (20) auf Seiten des Anschlussgitters (10), das die erste und die zweite Schaltung (5, 6) trägt, verwirklicht ist, um mit dem ersten Formteil einen Harzblock im Wesentlichen mit einer allgemeinen Spatform zu bilden, und dass das zweite Formteil auf dem ersten Formteil mit einer ersten Öffnung (53) für den Durchgang des von der ersten Schaltung (5) erzeugten Lichts, die mit dem ersten Formteil einen Aufnahmesitz für eine optische Linse (32) definiert, wobei die erste Öffnung eine größere Abmessung hat als die erste Lichtquellenschaltung, und mit einer zweiten Öffnung (52) für den Empfang des Lichts auf der zweiten Photoempfängerschaltung (6) hergestellt wird.

6. Verfahren nach einem der Ansprüche 1 und 4, **dadurch gekennzeichnet, dass** das erste lichtundurchlässige Formteil (20) auf dem Anschlussgitter (10) mit Hilfe von Positionierungslöchern (16) in den Anschluss-Leiterbahnen (12) des Gitters hergestellt wird, wobei sämtliche Positionierungslöcher vorzugsweise in der Anzahl vier durch die erste Formteil nicht verschlossen sind und sich in einer Richtung senkrecht zu dem Anschlussgitter (10) in der Umgebung der Ecken des Blocks des ersten Formteils (20), sobald er gebildet worden ist, befinden.

7. Verfahren nach Anspruch 6, **dadurch gekennzeichnet, dass** das zweite lichtundurchlässige Formteil (50) auf dem ersten lichtundurchlässigen Formteil (20) hergestellt wird, ohne zwei Positionierungslöcher (16) zu verschließen, die sich an zwei gegenüberliegenden Ecken eines einmal gebildeten Harzblocks, der durch das erste und die zweite Formteil gebildet ist, befinden, dass der Verbindungssteg oder der Verbindungsrahmen (11) des Anschlussgitters (10) unterbrochen werden und dass die Metall-Leiterbahnen (12), die von zwei gegenüberliegenden Seiten des Harzblocks ausgehen, gebogen werden, um elektrische Anschlusslaschen des optoelektronischen Moduls (1, 2) zu bilden.

8. Verfahren nach Anspruch 1, **dadurch gekennzeichnet, dass** dann, wenn das erste Formteil (20) auf dem Anschlussgitter (10) hergestellt worden ist, die erste und die zweite Schaltung (5, 6) auf einem Abschnitt der ersten bzw. der zweiten Metall-Leiterbahn (13, 14) befestigt werden und dass Kontaktbereiche der ersten und der zweiten Schaltung durch Anschluss-Metalldrähte (25) mit entsprechenden Bereichen des Anschlussgitters durch eine Erwärmung des Anschlussgitters, die auf der ersten und der dritten Metall-Leiterbahn (13, 15) durch die Durchgangsöffnung (21) hindurch erfolgt, verbunden werden.

9. Verfahren nach einem der Ansprüche 2, 5 und 7, **dadurch gekennzeichnet, dass** ein Block (3) aus lichtdurchlässigem Material, der wenigstens eine Linse (32) für die erste Lichtquellenschaltung (5) umfasst, hergestellt wird, um auf der ersten und der zweiten Öffnung (53, 52) des zweiten Formteils (50) hergestellt zu werden, wobei der Teil des lichtdurchlässigen Blocks, der mit dem zweiten Formteil in Kontakt gelangt, eine zu einer äußeren Oberfläche des zweiten Formteils komplementäre Form hat, derart, dass ein Abschnitt in Form einer Linse des lichtdurchlässigen Blocks in der ersten Öffnung (53) des zweiten Formteils angeordnet wird.

10. Verfahren nach Anspruch 9, für das der lichtdurchlässige Block (3) aus Glas oder einem Kunststoff hergestellt wird, **dadurch gekennzeichnet, dass** der lichtdurchlässige Block mit zwei Positionierungsstiften (35) hergestellt wird, um auf dem zweiten Formteil durch zwei Positionierungslöcher (16), die durch einen aus dem ersten und dem zweiten Formteil gebildeten Harzblock und durch das Anschlussgitter gebildet ist, montiert und positioniert zu werden.

11. Verfahren nach Anspruch 10, **dadurch gekennzeichnet, dass** der lichtdurchlässige Block an dem Harzblock durch Verriegelungsmittel (31), die einteilig mit dem lichtdurchlässigen Block gebildet sind, mechanisch befestigt ist oder an den Harzblock geklebt ist.

12. Optoelektronisches Modul (1, 2), das durch das Verfahren nach einem der vorhergehenden Ansprüche erhalten werden kann, wobei das Modul, montiert auf einer Seite eines Anschlussgitters (10), ausschließlich eine erste Lichtquellenschaltung (5), die auf einem Abschnitt einer ersten Leiterbahn (13) des Anschlussgitters angeordnet ist, und eine zweite Photoempfängerschaltung (6), die auf einem Abschnitt einer zweiten Leiterbahn (14) des Anschlussgitters angeordnet ist, umfasst, wobei die Kontaktbereiche der ersten und der zweiten Schaltung durch Metalldrähte (25) mit abgedeckten entsprechenden Bereichen bestimmter Leiterbahnen (12) des Anschlussgitters (10) verbunden sind, wobei die erste Lichtquellenschaltung über die erste Leiterbahn und eine dritte Leiterbahn mit Kontaktbereichen der zweiten Photoempfängerschaltung verbunden ist, wobei das Modul wenigstens ein erstes Formteil (20), das mit einem Einkapselungsmaterial auf einem mittleren Teil des Anschlussgitters hergestellt ist und eine bestimmte Anzahl von Anschluss-Leiterbahnen (12) aufweist, die von dem ersten Formteil ausgehen, umfasst, **dadurch gekennzeichnet, dass** die erste Lichtquellenschaltung mit der äußeren Umgebung nur über die zweite Photoempfängerschaltung verbunden ist, um sie vor elektrostatischen Entladungen zu schützen.

13. Optoelektronisches Modul nach Anspruch 12, **dadurch gekennzeichnet, dass** es ein zweites Formteil (50) umfasst, das mit einem Einkapselungsmaterial auf dem ersten Formteil (20) auf der die erste und die zweite Schaltung (5, 6) tragenden Seite des Anschlussgitters (10) hergestellt ist, um mit dem ersten Formteil einen Harzblock im Wesentlichen mit einer allgemeinem Spatform zu bilden, und dass das zweite Formteil auf dem ersten Formteil mit einer ersten Öffnung (53) für den Durchgang des von der ersten Schaltung erzeugten Lichts, die mit dem ersten Formteil einen Aufnahmesitz für eine optische Linse (32) definiert, wobei die erste Öffnung eine größere Abmessung als die erste Lichtquellenschaltung hat, und mit einer zweiten Öffnung (52) für den Empfang des Lichts auf der zweiten Photoempfängerschaltung hergestellt ist, wobei die zweite Öffnung in einem vorstehenden Teil (51) des zweiten lichtundurchlässigen Formteils in Form einer Membran verwirklicht ist, um einen Lichtdurchgang zu bilden, und dass das zweite Formteil hergestellt ist, um eine elektronische Signalverarbeitungszone der zweiten Photoempfängerschaltung abzudecken, während eine optoelektronische Zone der zweiten Photoempfängerschaltung dazu bestimmt ist, Licht durch den Lichtdurchgang des zweiten Formteils zu empfangen.

14. Optoelektronisches Modul nach Anspruch 13, **dadurch gekennzeichnet, dass** das Modul außerdem einen Block (3) aus lichtdurchlässigem Material umfasst, der auf der ersten und der zweiten Öffnung (53, 52) des zweiten Formteils montiert ist, wobei der Teil des lichtdurchlässigen Blocks, der mit dem zweiten Formteil in Kontakt gelangt, eine zu der äußeren Oberfläche des zweiten Formteils komplementäre Form hat, derart, dass ein Abschnitt in Form einer Linse (32) des lichtdurchlässigen Blocks in der ersten Öffnung (53) des zweiten Formteils für die erste Lichtquellenschaltung (5), die vorzugsweise eine Laserdiode ist, angeordnet wird.

15. Optoelektronisches Modul nach Anspruch 14, für das der lichtdurchlässige Block (3) aus Glas oder Kunststoff verwirklicht ist, **dadurch gekennzeichnet, dass** der lichtdurchlässige Block zwei Positionierungsstifte (35) umfasst, die in zwei Positionierungslöcher (16) eingesetzt sind, die in dem Harzblock verwirklicht sind, der durch das erste und das zweite Formteil (20, 50) gebildet ist, und dass der lichtdurchlässige Block an zwei gegenüberliegenden Seiten Verriegelungsmittel in Form von mit Haken versehenen Zungen (31) aufweist, um in einer Fläche des Harzblocks gegenüber der Kontaktfläche des lichtdurchlässigen Blocks auf dem zweiten Formteil zu verriegeln.

## Claims

1. Method of making an optoelectronic module (1, 2), which includes a first light source circuit (5) and a second photoreceptor circuit (6) able to pick up the light from the first light source circuit directly or by reflection onto an external surface, the method including the steps of:
- making a first moulding (20) with an encapsulation material on a lead frame (10) on which there are placed, prior to or after the first moulding and over at least one part (22, 23) of one face of the lead frame that is not covered by the first moulding, the first light source circuit (5) on one portion of a first conductive path (13) of the lead frame and the second photoreceptor circuit (6) on one portion of a second conductive path (14) of the lead frame, the first and second conductive connecting paths, and other conductive connecting paths (12) of the lead frame being connected outside the first moulding to at least one connecting bar (11), a through opening (21) being made in the first moulding (20) between the connecting bar and the location of the first light source circuit in order to give access to the first conductive path (13) and to a third conductive connecting path (15) for the first light source circuit,
- electrically connecting contact pads of the first and second circuits (5, 6) to corresponding uncovered pads of some conductive paths (12) of the lead frame (10), the first light source circuit being connected via the first and third conductive paths to contact pads of the second photoreceptor circuit, and
- cutting the first and third conductive connecting paths (13, 15) through the through opening (21) of the first moulding in order to electrically insulate the first light source circuit from the parts of the lead frame accessible outside the first moulding, said first light source circuit being connected to the exterior only via the second photoreceptor circuit, in order to protect the light source circuit from electrostatic discharge.

2. Method according to claim 1, **characterized in that** a second moulding (50) with an encapsulation material is made on the first moulding (20) so as to close the through opening (21) after the first and third conductive paths (13, 15) have been cut and to form a first aperture (53) on the first light source circuit for the passage of the light generated by said first circuit (5), and a second aperture for receiving light (52) on the second photoreceptor circuit (6).

3. Method according to claim 2, **characterized in that** the second aperture (52) is made in a projecting part (51) of the second opaque moulding (50) to form a light passage in the shape of a diaphragm, and **in that** the second moulding is made for covering an electronic processing zone for the signals of the second photoreceptor circuit, whereas an optoelectronic zone of the second photoreceptor circuit is for picking up light through the light passage of the second moulding.

4. Method according to any of the preceding claims, **characterized in that** the first opaque moulding (20) is made as a resin block of generally substantially parallelepiped shape on a central part of the lead frame (10), which includes several bars forming a connecting frame (11) for the metal conductive paths (12), outside the first moulding, an equal number of regularly spaced metal conductive paths coming out of two opposite sides of the resin block of the first moulding, whereas the first and third metal conductive paths (13, 15) for the first light source circuit (5) come out of a third side of said resin block.

5. Method according to any of claims 2 and 4, **characterized in that** the second opaque moulding (50) is made on the first opaque moulding (20) on the side of the lead frame (10) carrying the first and second circuits (5, 6), to form with the first moulding a resin block of generally substantially parallelepiped shape, and **in that** the second moulding is made on the first moulding with a first aperture (53) for the passage of the light generated by said first circuit (5), which defines with the first moulding a housing for an optical lens (32), said first aperture being of larger dimensions than the first light source circuit, and a second aperture (52) for receiving light on the second photoreceptor circuit (6).

6. Method according to any of claims 1 and 4, **characterized in that** the first opaque moulding (20) is made on the lead frame (10) using positioning holes (16) in conductive connecting paths (12) of the lead frame, said positioning holes, whose number is preferably equal to four, not being closed by the first moulding and located in a perpendicular direction to the lead frame (10) in proximity to the corners of the block of the first moulding (20) once made.

7. Method according to claim 6, **characterized in that** the second opaque moulding (50) is made on the first opaque moulding (20) without closing two positioning holes (16) located at two opposite corners of a resin block once made, which is formed by the first and second mouldings, **in that** the connecting bar or connecting frame (11) of the lead frame (10) are cut and **in that** the metal conductive paths (12) coming out of two opposite sides of the resin block are folded over to form electrical connecting pins for the optoelectronic module (1, 2).

8. Method according to claim 1, **characterized in that** after the first moulding (20) has been made on the lead frame (10), the first and second circuits (5, 6) are secured respectively on one portion of the first and second metal conductive paths (13, 14), and **in that** contact pads of the first and second circuits are connected by metal connecting wires (25) to corresponding pads of the lead frame by heating the lead frame, achieved by heating the first and third metal conductive paths (13, 15) through the through opening (21).

9. Method according to any of claims 2, 5 and 7, **characterized in that** a block of transparent material (3), which includes at least one lens (32) for the first light source circuit (5), is made in order to be mounted on the first and second apertures (53, 52) of the second moulding (50), the part of the transparent block coming into contact with the second moulding having a complementary shape to one external surface of the second moulding such that one lens shaped portion of the transparent block is housed in the first aperture (53) of the second moulding.

10. Method according to claim 9, wherein the transparent block (3) is made of glass or plastic material, **characterized in that** the transparent block is made with two positioning pins (35) in order to be mounted and positioned on the second moulding via two positioning holes (16) made through a resin block formed by the first and second mouldings, and the lead frame.

11. Method according to claim 10, **characterized in that** the transparent block is fixed to the resin block mechanically by hooking means (31) integral with the transparent block or bonded to the resin block.

12. Optoelectronic module (1, 2) which can be obtained by the method according to any of the preceding claims, said module including, mounted on one side of a lead frame (10) only a first light source circuit (5) placed on one portion of a first conductive path (13) of the lead frame, and a second photoreceptor circuit (6) placed on one portion of a second conductive path (14) of the lead frame, contact pads of the first and second circuits being connected by metal wires (25) to corresponding uncovered pads of some conductive paths (12) of the lead frame (10), said first light source circuit being connected via the first conductive path and a third conductive path to contact pads of the second photoreceptor circuit, the module including at least a first moulding (20) made with an encapsulation material on a central part of the lead frame, and a certain number of conductive connecting paths (12) coming out of the first moulding, **characterized in that** the first light source circuit only is connected to the outside via the second photoreceptor circuit in order to protect said light source circuit from electrostatic discharge.

13. Optoelectronic module according to claim 12, **characterized in that** it includes a second moulding (50) made with an encapsulation material on the first moulding (20) on the side of the lead frame (10) carrying the first and second circuits (5, 6), to form with the first moulding a resin block of generally substantially parallelepiped shape, **in that** the second moulding is made on the first moulding with a first aperture (53) for the passage of the light generated by said first circuit, which defines with the first moulding a housing for an optical lens (32), said first aperture being of larger dimensions than the first light source circuit, and a second aperture (52) for receiving light on the second photoreceptor circuit, said second aperture being made in a projecting portion (51) of the second opaque moulding to form a light passage in the shape of a diaphragm, and **in that** the second moulding is made for covering an electronic processing zone for the signals of the second photoreceptor circuit, whereas an optoelectronic zone of the second photoreceptor circuit is for picking up light through the light passage of the second moulding.

14. Optoelectronic module according to claim 13, **characterized in that** the module further includes a block of transparent material (3) mounted on the first and second apertures (53, 52) of the second moulding, the part of the transparent block that comes into contact with the second moulding having a complementary shape to one external surface of the second moulding such that one lens shaped portion (32) of the transparent block is housed in the first aperture (53) of the second moulding for the first light source circuit (5), which is preferably a laser diode.

15. Optoelectronic module according to claim 14, wherein the transparent block (3) is made of glass or plastic material, **characterized in that** the transparent block includes two positioning pins (35) inserted in two positioning holes (16) made in the resin block formed by the first and second mouldings (20, 50), and **in that** the transparent block includes, on two opposite sides, hooking means in the form of hooked tabs (31) for hooking onto one face of said resin block opposite to the contact face of the transparent block on the second moulding.
